# EUROPÄISCHE PATENTSCHRIFT

(11) **EP 3 699 660 B1**
(45) Veröffentlichungstag und Bekanntmachung des Hinweises auf die Patenterteilung: **21.12.2022**
(21) Anmeldenummer: 20152522.7
(22) Anmeldetag: 17.01.2020
(51) Int. Cl.: G02B 6/44, G02B 6/36, H05K 7/18, F16L 3/22

(54) **SCHALTSCHRANK MIT EINER LEERROHREINFÜHRUNG ZUR EINFÜHRUNG EINER VIELZAHL LICHTWELLENLEITER IN EINEN SCHALTSCHRANKINNENRAUM**
SWITCHGEAR CABINET WITH AN EMPTY PIPE LINE FOR INSERTING A PLURALITY OF OPTICAL WAVEGUIDES INTO A SWITCHGEAR CABINET
ARMOIRE DE DISTRIBUTION DOTÉE D'UNE ENTRÉE DE TUYAU VIDE PERMETTANT L'ENTRÉE D'UNE PLURALITÉ DE CÂBLES À FIBRE OPTIQUE DANS UN ESPACE INTÉRIEUR D'ARMOIRE DE DISTRIBUTION

(30) Priorität: 25.02.2019 DE 202019101080 U
(43) Veröffentlichungstag der Anmeldung: 26.08.2020
(73) Patentinhaber: Rittal GmbH & Co. KG, 35745 Herborn (DE)
(72) Erfinder: Müller, Stephan, 35768 Siegbach-Oberndorf (DE); Markus, Deusing, 35688 Dillenburg (DE)
(74) Vertreter: Angerhausen, Christoph

(56) Entgegenhaltungen:
- EP-A1- 2 661 092
- EP-A2- 2 450 729
- WO-A1-2017/114936
- DE-C1- 3 538 485
- JP-A- S5 928 105
- US-A- 4 898 448
- US-A1- 2002 197 047
- US-A1- 2003 223 700
- US-A1- 2010 125 998
- US-A1- 2011 091 170
- US-A1- 2014 270 677

## Beschreibung

Die Erfindung betrifft einen Schaltschrank mit einer Leerrohreinführung zur Einführung einer Vielzahl Lichtwellenleiter in einen Schaltschrankinnenraum gemäß den Ansprüchen 1 und 2. Ein Schaltschrank gemäß den Oberbegriffen der Ansprüche 1 und 2 ist aus der US 2011/091170 A1 bekannt. Ähnliche Schaltschränke beschreiben auch die US 2003/223700 A1, die US 2002/197047 A1 und die DE 3538485 C1. Eine Leerrohreinführung ist aus der EP 3 324 230 A1 bekannt. Eine ähnliche Anordnung beschreibt auch die EP 1777 563 B1.

Die Verlegung von Glasfaserleitungen erfolgt überwiegend in Kunststoffrohrverbänden in der Art, dass zuerst Leerrohre verlegt und anschließend die Glasfaserleitungen in die vorhandenen Leerrohre eingeblasen werden. Hierzu werden beispielsweise bis zu 120 Leerrohre in ein Schaltschrankgehäuse meistens über dessen Bodenseite eingeführt. Die Lehrrohre müssen abgedichtet und insbesondere einzeln zugentlastet werden. Dazu ist bisher vorgesehen, dass je Leerrohr eine Rohrschelle oder eine Sicherungsscheibe manuell betätigt wird, um das betreffende Leerrohr zu arretieren.

Es ist daher die Aufgabe der Erfindung, einen Schaltschrank mit einer Leerrohreinführung der eingangs beschriebenen Art derart weiterzuentwickeln, dass er einen geringeren Montageaufwand aufweist, insbesondere hinsichtlich der Zugentlastung der Leerrohre.

Diese Aufgabe wird durch einen Schaltschrank mit den Merkmalen der Ansprüche 1 und 2 gelöst.

Vorteilhafte Ausführungsformen der Erfindung sind jeweils Gegenstand der abhängigen Ansprüche.

Demgemäß ist vorgesehen, dass bei einem Schaltschrank mit einer Leerrohreinführung zur Einführung einer Vielzahl Lichtwellenleiter durch eine Wand des Schaltschranks in einen Schaltschrankinnenraum die Leerrohreinführung zwei parallel zueinander verschiebliche Schieber aufweist, die jeweils eine Mehrzahl Durchlässe aufweisen, die paarweise zumindest anteilig fluchten, wobei die Leerrohreinführung weiterhin ein Arretierungsmittel aufweist, mit dem die beiden Schieber zueinander arretierbar sind. Die Leerrohreinführung zeichnet sich dadurch aus, dass sie weiterhin einen Antrieb aufweist, über den die beiden Schieber parallel zueinander verschieblich sind, wobei der Antrieb eine Gewindeschraube mit unrundem Schraubenkopf aufweist, die über ihren unrunden Schraubenkopf an einem Innenrand eines Durchbruchs durch einen der beiden Schieber oder durch beide Schieber anliegt.

Die beschriebene Leerrohreinführung erlaubt es, dass in einem ersten Montageschritt die Leerrohre durch die paarweise fluchtenden Durchlässe in den beiden Schiebern der Leerrohreinführung hindurchgeführt und anschließend sämtliche Leerrohre durch Verschieben der beiden Schieber zueinander fixiert und damit zugentlastet werden. Durch das Verschieben der beiden Schieber zueinander kann sich der Durchlassquerschnitt der fluchtenden Durchlässe verändern, insbesondere verringern, so dass die Leerrohre in den fluchtenden Durchlässen der beiden Schieber eingeklemmt werden. In dieser Position können dann die beiden Schieber der Leerrohreinführung mit Hilfe des Arretierungsmittels zueinander arretiert werden, um eine dauerhafte Zugentlastung der Leerrohre zu erreichen. Wenn die Leerrohre aus einem elastischen Material gefertigt sind, so ist sichergestellt, dass sie aufgrund ihrer Eigenspannung sicher in den paarweise fluchtenden Durchlässen der beiden Schieber arretiert sind.

Dass die Schieber parallel zueinander verschieblich sind, ist insbesondere dann vorteilhaft, wenn die Schieber im Wesentlichen plattenförmig ausgebildet sind. Einer der Schieber kann als ein Bodenelement des Schaltschranks, beispielsweise als eine Flanschplatte ausgeführt sein. Dieser Schieber kann starr angeordnet, insbesondere unbeweglich mit dem Schaltschrank verbunden sein, beispielsweise ein Wandelement, des Schaltschranks sein, etwa ein Bodenelement, eine Seitenwand, oder ein Dachelement.

Die paarweise zumindest anteilig fluchtenden Durchlässe können geometrisch im Wesentlichen identisch ausgebildet sein. Sie können beispielsweise als kreisrunde Durchgangsbohrungen entsprechend einem Rohrquerschnitt der verwendeten Leerrohre ausgebildet sein. Es kann vorgesehen sein, dass die Geometrie der Durchlässe gerade derart in Bezug auf die Außengeometrie der Leerrohre angepasst ist, dass auch bei maximal miteinander fluchtenden Durchlässen die Rohre bereits im Formschluss und/oder unter einem Reibwiderstand mit den Durchlässen stehen, wenn sie manuell in die fluchtenden Durchlässe eingesetzt werden, so dass bereits in diesem Stadium des Montagevorgangs eine gewisse Vorausrichtung der Leerrohre erreicht wird. Wenn dann sämtliche Leerrohre eingesetzt sind, kann durch Verschieben der beiden Schieber zueinander die endgültige Arretierung der Leerrohre mit hoher Arretierungssicherheit hergestellt werden.

Die beiden Schieber können als aufeinanderliegende Schieberplatten und die Durchlässe als Durchlässe senkrecht zu einer jeweiligen Plattenebene durch die Schieberplatten ausgebildet sein.

Einer von dem Schaltschrankinnenraum abgewandten Außenseite des Äußeren der beiden Schieber kann ein Dichtelement vorgelagert sein. Das Dichtelement kann beispielsweise eine Moosgummidichtung aufweisen oder sein. Das Dichtelement kann an der Außenseite befestigt sein. Eine Mehrzahl Leerrohre kann durch das Dichtelement hindurchgeführt sein, wobei die Leerrohre an ihrem Außenumfang fluidisch dichtend von dem Dichtelement umschlossen sind.

Zumindest für einen Teil der paarweise fluchtenden Durchlässe kann je Paar fluchtender Durchlässe ein Leerrohr von der Außenseite des Schaltschranks durch das Dichtelement und das Paar fluchtender Durchlässe hindurch in den Schaltschrankinnenraum eingeführt sein.

Das Dichtelement kann für sämtliche der paarweise fluchtenden Durchlässe der beiden Schieber jeweils einen weiteren Durchlass aufweisen, der mit den paarweise fluchtenden Durchlässen der Schieber fluchtet.

Einer der beiden Schieber kann an der Wand des Schaltschranks unbeweglich festgelegt und der andere Schieber dem Schaltschrankinnenraum zugewandt und in Bezug auf den unbeweglichen Schieber verschieblich sein.

Die Leerrohreinführung weist einen Antrieb auf, über den die beiden Schieber parallel zueinander verschieblich sind. Der Antrieb weist eine Gewindeschraube mit unrundem Schraubenkopf, beispielsweise eine Spiralspannschraube auf.

Die Gewindeschraube beziehungsweise die Spiralspannschraube liegt über ihren unrunden Schraubenkopf an einem Innenrand eines Durchbruchs durch eine der beiden Schieber oder durch beide Schieber an.

Die Gewindeschraube beziehungsweise die Spiralspannschraube kann über ihren unrunden Schraubenkopf an gegenüberliegenden Innenrändern fluchtender Durchbrüche durch die beiden Schieber anliegen. Dabei können die Innenränder in der Richtung, in der die beiden Schieber zueinander verschieblich sind, sich gegenüberliegend angeordnet sein. Der unrunde Schraubenkopf kann dabei an jeweils einem der beiden Innenränder jeweils eines der beiden Durchbrüche anliegen.

In einer alternativen Ausgestaltung der Erfindung ist der Antrieb mehrteilig ausgebildet und weist eine Spannmutter auf, die an ihrer den Schiebern zugewandten Seite eine Spannspirale aufweist, über die die Spannmutter in einen Durchbruch durch einen der beiden Schieber oder durch beide Schieber eintaucht. Die Spannspirale ist exzentrisch um einen Bolzendurchlass für eine Gewindeschraube ausgebildeltund weist an ihrem Außenumfang einen vorspringenden Winkelanschlag auf. Die Spannmutter kann mit Hilfe einer sich durch den Bolzendurchlass hindurch in ein Innengewinde hinein erstreckenden Gewindeschraube in einer gewünschten Stellposition arretiert sein.

Über eine Mehrzahl der paarweise fluchtenden Durchlässe kann jeweils ein elastisches Leerrohr, beispielsweise ein Kunststoffrohr, in den Schaltschrankinnenraum eingeführt sein, wobei die beiden Schieber über den Antrieb unter elastischer Verformung der Leerrohre und somit entgegen einer Rückstellkraft zueinander verspannt sind.

Das Arretierungsmittel kann eine Gewindeaufnahme in einem der beiden Schieber mit einem darin eingeschraubten Schraubelement sowie ein Langloch beziehungsweise ein Schlüsselloch durch den anderen Schieber aufweisen, das sich in der Richtung erstreckt, in der die beiden Schieber zueinander verschieblich sind und das mit der Gewindeaufnahme fluchtet.

Gemäß einem anderen, nicht zur Erfindung gehörendem Aspekt wird ein Schaltschrank mit einer Leerrohreinführung zur Einführung einer Vielzahl Lichtwellenleiter durch eine Wand des Schaltschranks in einen Schaltschrankinnenraum beschrieben, bei dem die Leerrohreinführung eine Mehrzahl Haltemodule für die Positionierung und Arretierung einer Mehrzahl Lichtwellenleiterenden aufweist, wobei die Haltemodule jeweils eine Mehrzahl Klammern jeweils für die Arretierung eines Endes eines Leerrohres für einen Lichtwellenleiter aufweisen. Die Klammern sind in einer Reihe und in Tiefenrichtung des Haltemoduls abgestuft angeordnet, wobei eine hinterste der Klammern am höchsten und eine vorderste der Klammern am niedrigsten angeordnet ist. Ein oder mehrerer nebeneinander angeordnete Haltmodule können die Leerrohreinführung bilden.

Das Haltemodul kann für jedes Leerrohr eine Zugentlastung aufweisen. Das Haltemodul kann die Klammer einer der jeweiligen Klammern der unter demselben Abstand vorgelagerten Lichtwellenleiterführung aufweisen.

Das Haltemodul kann je Klammer einen Durchgriff durch das Haltemodul hindurch aufweisen, über den die jeweilige Klammer von gegenüberliegenden Seiten des Haltemoduls zugänglich ist.

Weitere Einzelheiten werden anhand der nachstehenden Figuren erläutert. Dabei zeigt:
- Figur 1: eine Ausführungsform eines erfindungsgemäßen Schaltschranks in perspektivische Darstellung;
- Figur 2: eine Detailansicht der Ausführungsform gemäß Figur 1;
- Figur 3: eine weitere Ausführungsform, die nicht Teil der beanspruchten Erfindung ist, Dichtwellenleitereinführung mit einer Detailansicht davon;
- Figur 4: eine Detailansicht einer weiteren Ausführungsform einer erfindungsgemäßen Dichtwellenleitereinführung; und
- Figur 4a: eine Querschnittsansicht der Ausführungsform nach Figur 4;
- Figur 5: eine Gewindeschraube gemäß einer Ausführungsform der Erfindung; und
- Figur 6: ein Antrieb gemäß einer Ausführungsform der Erfindung unter Verwendung der Gewindeschraube nach Anspruch 5.

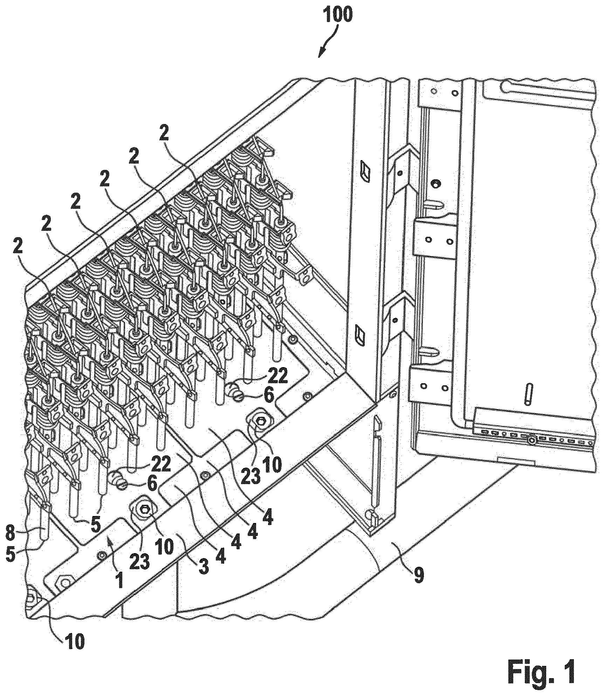

Die Figur 1 zeigt eine beispielhafte Ausführungsform eines erfindungsgemäßen Schaltschranks 100 mit einer Leerrohreinführung 1, über die eine Vielzahl Lichtwellenleiter 2 durch eine horizontale untere Wand 3 des Schaltschrankgehäuses in das Innere des Schaltschranks 100 eingeführt ist. Die Wand 3 ist vorliegend ein unteres Bodenblech des Schaltschrankgehäuses, welches beabstandet von der Aufstandsseite des Schaltschranks den Schaltschrankinnenraum nach unten begrenzt. Über ein Zuführrohr 9 sind die Lichtwellenleiter 2 und die Lehrrohre 8, in welchen die Lichtwellenleiter 2 jeweils aufgenommen sind, dem Schaltschrank 100 an seiner Unterseite zugeführt, so dass die Lichtwellenleiter 2 und die Lehrrohre 8 mit Hilfe der Leerrohreinführung 1 durch die Bodenwand 3 in das Schaltschrankgehäuse 100 eingeführt werden können.

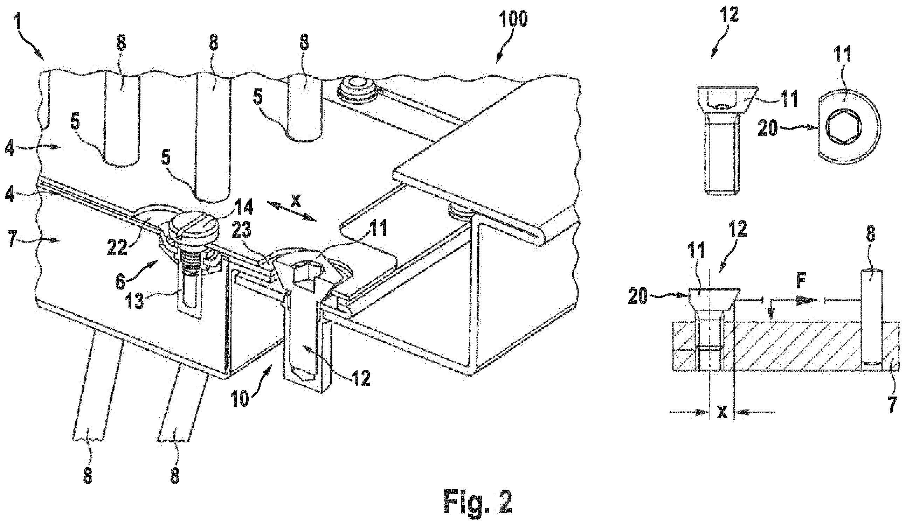

Die Leerrohreinführung 1 ist in der Zusammenschau der Figuren 1 und 2 im Detail zu erkennen. Die Leerrohreinführung 1 besteht im Wesentlichen aus zwei Schiebern 4, die als Schieberplatten ausgebildet sind und entlang einer Verschieberichtung x aufeinander liegend zueinander verschieblich sind. Die beiden Schieber 4 weisen eine Vielzahl paarweise fluchtender Durchlässe 5 auf, durch welche jeweils ein Leerrohr 8 hindurchgeführt ist. Die Geometrie der Durchlässe 5 ist auf die Außengeometrie der Leerrohre 8 abgestimmt, so dass die Leerrohre 8 im Wesentlichen spielfrei durch die fluchtenden Durchlässe hindurchgeführt werden können. Unterhalb des unteren Schiebers 4, mithin vom Schaltschrankinnenraum abgewandt, ist ein Dichtelement 7, beispielsweise eine Moosgummidichtung, angrenzend an den unteren Schieber 4 angeordnet und/oder an diesem befestigt, so dass eine fluidische Abdichtung der Durchlässe 5 zur Umgebung des Schaltschranks 100 erreicht wird.

Die gezeigte Leerrohreinführung 1 hat insbesondere den Vorteil, dass sie für eine Vielzahl Leerrohre 8 gleichzeitig und mit geringem Montageaufwand eine Zugentlastung ermöglicht. Dazu können in einem ersten Schritt die beiden Schieber 4 derart übereinander gelegt werden, dass die paarweise fluchtenden Durchlässe 5 in den Schiebern 4 mit einem maximalen Querschnitt überlappen, so dass die Rohre 8 im Wesentlichen widerstandslos, gegebenenfalls formschlüssig und allenfalls noch unter einem Reibwiderstand durch die paarweise fluchtenden Durchlässe der beiden Schieber 4 hindurchgeführt werden können. Um die Ausrichtung der beiden Schieber 4 für die Einführung der Rohre zu erleichtern, kann beispielsweise ein Arretierungsmittel 6 ein schlüssellochförmiges Langloch 15 aufweisen sowie eine Gewindeschraube 14, die in einer Gewindeaufnahme 13 aufgenommen ist, wobei der Schraubenkopf 14 derart bemessen ist, dass er über das weite Ende des schlüssellochförmigen Langlochs nur dann einführbar ist, wenn die beiden Schieber 4 so zueinander angeordnet sind, dass die paarweise fluchtenden Durchlässe 5 mit einem gewünschten, vorzugsweise maximalen Querschnitt miteinander fluchten.

Nachdem die Leerrohre durch die paarweise fluchtenden Durchlässe 5 in den beiden

Schiebern 4 eingesetzt worden sind, werden die beiden Schieber 4 in der Verschieberichtung x parallel zu ihrer jeweiligen Schieberebene zueinander verschoben, um die Leerrohre 8 in den paarweise fluchtenden Durchlässen 5 zu verspannen. Dazu können die Leerrohre 8 vorzugsweise aus einem elastischen Material, beispielsweise aus einem Kunststoffmaterial ausgebildet sein, welches eine elastische Deformation erlaubt. Verständlicherweise werden die beiden Schieber 4 gerade so weit zueinander verschoben, dass zwar eine Verspannung der Leerrohre 8 in den paarweise fluchtenden Durchlässen 5 erreicht, jedoch ebenso sichergestellt wird, dass die durch die Leerrohre 8 hindurchgeführten Lichtwellenleiter 2 nicht beschädigt werden. Für das definierte Verschieben der beiden Schieber 4 zueinander zur Verspannung der Leerrohre 8 ist der Antrieb 10 als eine Gewindeschraube 12 mit einem unrunden Schraubenkopf 11 ausgebildet, beispielsweise als eine Spiralspannschraube.

Nachdem die beiden Schieber 4 unter elastischer Verformung der Leerrohre 8 zueinander verspannt worden sind, können die beiden Schieber 4 in dieser Arretierungsposition, in welche die Leerrohre 8 eine Zugentlastung aufweisen, mit Hilfe der Arretierungsschraube 14 der Arretierung 6 in dem Langloch beziehungsweise Schlüsselloch 15 arretiert werden. Dazu weist die Schraube 14 einen Schraubenkopf auf, der einen Durchmesser aufweist, der größer als eine maximale Breite des Langlochs 15 beziehungsweise größer als eine Breite des Schlüssellochs an seinem schmalen Ende ist.

Es kann insbesondere vorgesehen sein, dass der in der Darstellung untere Schieber 4 fest mit dem Schaltschrank 100 beziehungsweise der Wand 3 verbunden oder ein Teil der Wand 3 ist, während der obere Schieber 4 gegenüber dem unteren Schieber 4 bzw. der Wand 3 verschieblich ist. Dazu kann der untere Schieber 4 beispielsweise nach Art einer Flanschplatte ausgebildet sein, die einen unteren Durchlass des Schaltschrankgehäuses durch das Bodenblech bis auf die Durchlässe 5 des unteren Schiebers verschließt. Der untere Schieber 4 beziehungsweise die Flanschplatte kann an seiner/ihrer dem oberen Schieber 4 abgewandten Außenseite eine Gewindeaufnahme für die Aufnahme der Arretierungsschraube 14 aufweisen. Das zum Schaltschrankinnern offene entsprechende Innengewinde 13 kann ebenfalls mit Hilfe des Dichtelements 7, insbesondere mit einer Moosgummidichtung verschlossen sein, um die erforderliche IP-Schutzklasse zu erreichen.

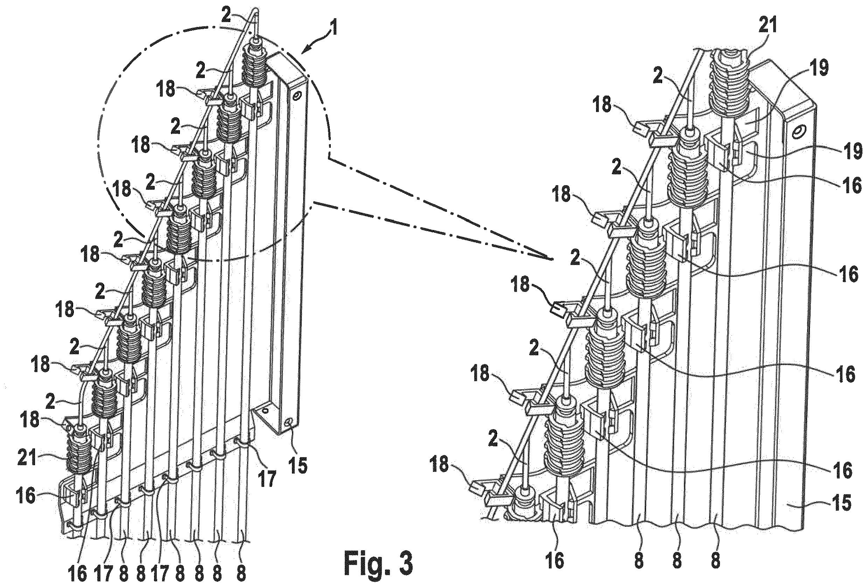

Die Figur 3 zeigt eine alternative Ausführungsform, die nicht Teil der beanspruchten Erfindung ist, einer Leerrohreinführung 1zur Einführung einer Vielzahl Lichtwellenleiter 2 durch eine Wand 3 eines Schaltschranks 100 in einen Schaltschrankinnenraum. Obwohl die Wand 3 und der Schaltschrank 100 nicht dargestellt sind, können sie grundsätzlich derart ausgebildet sein, wie sie mit Bezug auf die Figuren 1 und 2 beschrieben worden sind. Die Lehrrohreinführung 1 weist mindestens eine und vorzugsweise eine Mehrzahl der in Figur 3 gezeigten Haltemodule 15 für die Positionierung und Arretierung einer Mehrzahl Lichtwellenleiterenden auf. Die Haltemodule 15 weisen wiederum jeweils eine Mehrzahl Klammern 16 für die Arretierung eines Endes eines Leerrohres 8 für einen Lichtwellenleiter 2 auf. Die Klammern 16 sind in einer Reihe und in Tiefenrichtung des Haltemoduls 15 abgestuft angeordnet. Eine hinterste der Klammern 16 ist am höchsten und eine vorderste der Klammern 16 am niedrigsten angeordnet, so dass sich die in der Figur 3 gezeigte abgestufte Anordnung der Enden der Leerrohre 8 ergibt und damit von der Vorderseite des Moduls 15 sämtliche Enden der Lehrrohre einfach zu erreichen sind. Auf die Enden der Leerrohre ist jeweils eine Leerrohrabdichtung 21 aufgesetzt, über welche die Lichtwellenleiter 2 aus dem Leerrohr 8 heraustreten. Nachdem ein Lichtwellenleiter 2 aus einem Leerrohr 8 austritt, wird er von einer Lichtwellenleiterführung 18 in eine gemeinsame Verlegebahn der Lichtwellenleiter 2 des Moduls 15 gelenkt. Dazu kann das Haltemodul 15 je Klammern 16 eine der jeweiligen Klammer 16 unter demselben Abstand vorgelagerte Lichtwellenleiterführung 18 aufweisen.

Weiterhin weist das Haltemodul an seinem unteren Ende für jedes Leerrohr 8 eine das jeweilige Rohr 8 umschließende Zugentlastung 17 auf. Zusätzlich weist das Haltemodul 15 je Klammer 16 einen Durchgriff 19 durch das Haltemodul 15 auf, über den die jeweilige Halteklammer 16 von gegenüberliegenden Seiten des Haltemoduls zugänglich ist, wodurch das Einsetzen der Leerrohre in die Klammern 16 erleichtert wird.

Für die Montage der Leerrohre 8 beziehungsweise der Lichtwellenleiter 2 an dem Haltemodul 15 können in einem ersten Schritt die Leerrohre 8 in der in Figur 3 gezeigten abgestuften Anordnung mit Hilfe der Halteklammer 16 positioniert und mit Hilfe der Zugentlastungen 17 am unteren Ende des Haltemoduls 15 arretiert werden. Je nach Anwendungsfall können eine Mehrzahl der in Figur 3 gezeigten Haltemodule 15 mit Leerrohren 8 vorbereitet werden, um anschließend nebeneinander angeordnet eine entsprechend größere Leerrohreinführung zu bilden. Nachdem die aus einem oder mehreren der Module 15 zusammengesetzte Leerrohreinführung 1 erzeugt worden ist, können die Lichtwellenleiter 2 in die einzelnen Leerrohre 8 eingeblasen und mit Hilfe der Lichtwellenleiterführung 18 definiert verlegt werden. Gegenüber den aus dem Stand der Technik bekannten Lichtwellenleiterführungen wird somit eine einfachere Montage sowie ein hochgradig geordnetes Lichtwellenleitermanagement erreicht.

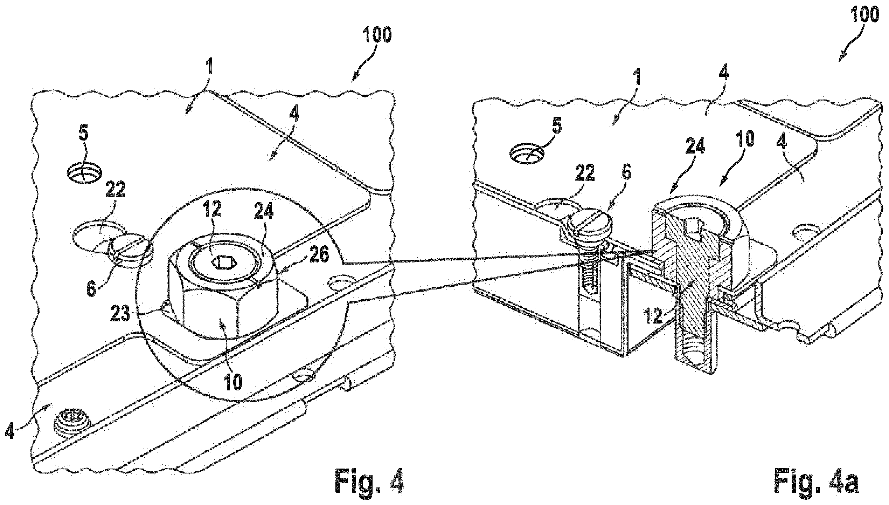

Die Figuren 4 bis 6 beschreiben eine weitere erfindungsgemäße Ausführungsform einer in einem Schaltschrank 100 aufgenommenen Lehrrohreinführung 1, die sich insbesondere durch die Ausgestaltung des Antriebs 100 von den Ausführungsformen unterscheidet, die mit Bezug auf die vorangegangenen Figuren 1 bis 2 beschrieben worden sind. Demgemäß ist der Antrieb 10 zweiteilig ausgeführt, mit einer zentralen Gewindeschraube 12 und einer Spannmutter 24, die an Ihrem Außenumfang einen Mehrkantantrieb 26 aufweist. Die Spannmutter 24 weist einen zentralen Durchlass auf, durch welchen sich die Spannschraube 12 hindurch erstreckt und analog zu den vorangegangenen Ausführungsformen in eine Gewindeaufnahme eingeschraubt ist.

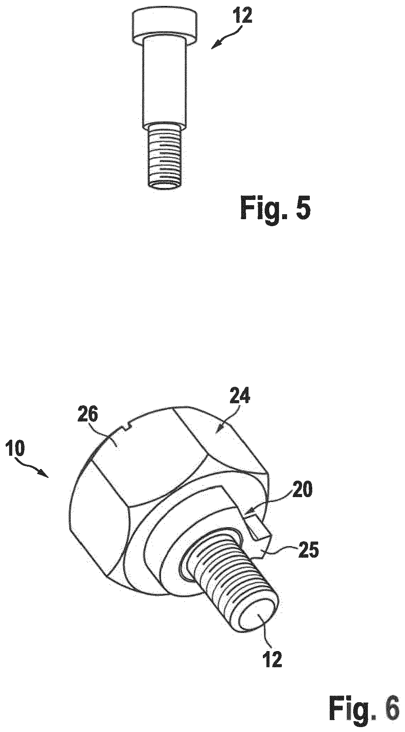

Wie in Figur 6 zu erkennen ist, weist die Spannmutter 24 an ihrer den Schiebern 4 zugewandten Seite eine Spannspirale einer Abflachung 20 auf, über welche die Spannmutter 24 in den Durchbruch 23 des Schiebers 4 eintaucht. Angeformt an die Abflachung 20 weist die Spannmutter 24 einen Winkelanschlag 25 auf. Die Abflachung 20 und der Winkelanschlag 25 sind am Außenumfang einer Spannspirale ausgebildet, deren Außenumfang sich exzentrisch zu der Gewindeschraube 12 erstreckt, sodass die Spannmutter 24 eine Selbsthemmung aufweist.

Gegenüber der mit Bezug auf die Figuren 1 bis 2 beschriebenen Ausführungsform hat die zweiteilige Ausführung des Antriebs 10 gemäß den Figuren 4 bis 6 den Vorteil, dass die Spannmutter 24 keine Höhenbewegung beim Verdrehen erfährt, da sie von der Gewindeschraube 12 entkoppelt ist. Der Spannvorgang wird dadurch deutlicher maßlich eingrenzbar. Der Winkelanschlag 25 verhindert zusätzlich ein Überdrehen und gibt dem Anwender eine haptische Rückkopplung für den erfolgten Spannvorgang.

### Bezugszeichenliste

- 1: Leerrohreinführung
- 2: Lichtwellenleiter
- 3: Wand
- 4: Schieber
- 5: Durchlass
- 6: Arretierungsmittel
- 7: Dichtelement
- 8: Leerrohr
- 9: Zuführrohr
- 10: Antrieb
- 11: Schraubenkopf
- 12: Gewindeschraube
- 13: Gewindeaufnahme
- 14: Schraubelement
- 15: Haltemodul
- 16: Klammer
- 17: Zugentlastung
- 18: Lichtwellenleiterführung
- 19: Durchgriff
- 20: Abflachung
- 21: Leerrohrabdichtung
- 22: Langloch
- 23: Durchbruch
- 24: Spannmutter
- 25: Winkelanschlag
- 26: Mehrkantantrieb

- 100: Schaltschrank
- x: Verschieberichtung

## Patentansprüche

1. Schaltschrank (100) mit einer Leerrohreinführung (1) zur Einführung einer Vielzahl Lichtwellenleiter (2) durch eine Wand (3) des Schaltschranks (100) in einen Schaltschrankinnenraum, wobei die Leerrohreinführung (1) zwei parallel zueinander verschiebliche Schieber (4) aufweist, die jeweils eine Mehrzahl Durchlässe (5) aufweisen, die paarweise zumindest anteilig fluchten, wobei die Leerrohreinführung (1) ein Arretierungsmittel (6) aufweist, mit dem die Schieber (4) zueinander arretierbar sind, **dadurch gekennzeichnet, dass** die Leerrohreinführung (1) weiterhin einen Antrieb (10) aufweist, über den die beiden Schieber (4) parallel zueinander verschieblich sind, wobei der Antrieb (10) eine Gewindeschraube (12) mit unrundem Schraubenkopf (11) aufweist, die über ihren unrunden Schraubenkopf (11) an einem Innenrand eines Durchbruchs (23) durch einen der beiden Schieber (4) oder durch beide Schieber (4) anliegt.

2. Schaltschrank (100) mit einer Leerrohreinführung (1) zur Einführung einer Vielzahl Lichtwellenleiter (2) durch eine Wand (3) des Schaltschranks (100) in einen Schaltschrankinnenraum, wobei die Leerrohreinführung (1) zwei parallel zueinander verschiebliche Schieber (4) aufweist, die jeweils eine Mehrzahl Durchlässe (5) aufweisen, die paarweise zumindest anteilig fluchten, wobei die Leerrohreinführung (1) ein Arretierungsmittel (6) aufweist, mit dem die Schieber (4) zueinander arretierbar sind, **dadurch gekennzeichnet, dass** die Leerrohreinführung (1) weiterhin einen Antrieb (10) aufweist, wobei der Antrieb (10) eine Spannmutter (24) aufweist, die an ihrer den Schiebern (4) zugewandten Seite eine Spannspirale aufweist, über die die Spannmutter (24) in einen Durchbruch (23) durch einen der beiden Schieber (4) oder durch beide Schieber (4) eintaucht und die exzentrisch um einen Bolzendurchlass für eine Gewindeschraube (12) ausgebildet ist und an ihrem Außenumfang einen vorspringenden Winkelanschlag aufweist.

3. Schaltschrank (100) nach Anspruch 1 oder 2, bei dem die paarweise zumindest anteilig fluchtenden Durchlässe (5) geometrisch im Wesentlichen identisch ausgebildet sind.

4. Schaltschrank (100) nach einem der vorangegangenen Ansprüche, bei dem die beiden Schieber (4) als aufeinander liegende Schieberplatten und die Durchlässe (5) als Durchlässe (5) senkrecht zur jeweiligen Plattenebene durch die Schieberplatte ausgebildet sind.

5. Schaltschrank (100) nach einem der vorangegangenen Ansprüche, bei dem einer von dem Schaltschrankinnenraum abgewandten Außenseite der äußeren der beiden Schieber (4) ein Dichtelement (7) vorgelagert ist.

6. Schaltschrank (100) nach Anspruch 5, bei dem das Dichtelement (7) eine Moosgummidichtung aufweist oder ist.

7. Schaltschrank (100) nach Anspruch 5 oder 6, bei dem eine Mehrzahl Leerrohre (8) durch das Dichtelement (7) hindurchgeführt sind, wobei die Leerrohre (8) an ihrem Außenumfang fluidisch dichtend von dem Dichtelement (7) umschlossen sind.

8. Schaltschrank (100) nach einem der Ansprüche 5 bis 7, bei dem zumindest für einen Teil der paarweise fluchtenden Durchlässe (5) je Paar fluchtender Durchlässe (5) ein Leerrohr (8) von der Außenseite des Schaltschranks (100) durch das Dichtelement (7) und das Paar fluchtender Durchlässe (5) hindurch in den Schaltschrankinnenraum eingeführt ist.

9. Schaltschrank (100) nach einem der Ansprüche 5 bis 8, bei dem das Dichtelement (7) für sämtliche der paarweise fluchtenden Durchlässe (5) der Schieber (4) jeweils einen weiteren Durchlass aufweist, der mit den paarweise fluchtenden Durchlässen (5) der Schieber (4) fluchtet.

10. Schaltschrank (100) nach einem der vorangegangenen Ansprüche, bei dem einer der beiden Schieber (4) an der Wand (3) des Schaltschranks (100) unbeweglich festgelegt und der andere Schieber (4) dem Schaltschrankinnenraum zugewandt und in Bezug auf den unbeweglichen Schieber (4) verschieblich ist.

11. Schaltschrank (100) nach Anspruch 1, bei dem die Gewindeschraube (12) mit unrundem Schraubenkopf (11) eine Spiralspannschraube ist.

12. Schaltschrank (100) nach Anspruch 1 oder 11, bei dem die Gewindeschraube (12) bzw. die Spiralspannschraube über ihren unrunden Schraubenkopf (11) an gegenüber liegenden Innenrändern fluchtender Durchbrüche (23) durch die beiden Schieber (4) anliegt.

13. Schaltschrank (100) nach Anspruch 12, bei dem die Innenränder in der Richtung, in der die beiden Schieber (4) zueinander verschieblich sind, sich gegenüber liegend angeordnet sind.

14. Schaltschrank (100) nach Anspruch 1 oder 2, bei dem über eine Mehrzahl der paarweise fluchtenden Durchlässe (5) jeweils ein elastisches Leerrohr (8), beispielweise ein Kunststoffrohr, in den Schaltschrankinnenraum eingeführt ist, wobei die beiden Schieber (4) über den Antrieb (10) unter elastischer Verformung der Leerrohre (8) und somit entgegen einer Rückstellkraft zueinander verspannt sind.

15. Schaltschrank (100) nach einem der vorangegangenen Ansprüche, bei dem das Arretierungsmittel (6) eine Gewindeaufnahme (13) in einem der beiden Schieber (4) mit einem darin eingeschraubten Schraubelement (14) sowie ein Langloch (22) oder ein Schlüsselloch durch den anderen Schieber (4) aufweist, das sich in der Richtung erstreckt, in der die beiden Schieber (4) zueinander verschieblich sind und das mit der Gewindeaufnahme (13) fluchtet.

## Claims

1. A switch cabinet (100) having an empty conduit inlet (1) for introducing a multiplicity of optical waveguides (2) through a wall (3) of the switch cabinet (100) into a switch cabinet interior, the empty conduit inlet (1) having two slides (4) which can be displaced parallel to one another and each have a plurality of passages (5) which are at least partially aligned in pairs, the empty conduit inlet (1) having a locking means (6), by means of which the slides (4) can be locked relative to one another, **characterized in that** the empty pipe inlet (1) furthermore has a drive (10) via which the two slides (4) can be displaced parallel to one another, the drive (10) having a threaded screw (12) with a non-circular screw head (11) which, via its non-circular screw head (11), bears against an inner edge of an opening (23) through one of the two slides (4) or through both slides (4).

2. A switch cabinet (100) having an empty conduit inlet (1) for introducing a multiplicity of optical waveguides (2) through a wall (3) of the switch cabinet (100) into a switch cabinet interior, the empty conduit inlet (1) having two slides (4) which can be displaced parallel to one another and each have a plurality of passages (5) which are at least partially aligned in pairs, the empty conduit inlet (1) having a locking means (6) with which the slides (4) can be locked relative to one another **characterized in that** the empty pipe inlet (1) further has a drive (10), the drive (10) having a clamping nut (24) which, on its side facing the slides (4), has a clamping spiral via which the clamping nut (24) plunges into an opening (23) through one of the two slides (4) or through both slides (4) and which is designed eccentrically around a bolt passage for a threaded screw (12) and has a projecting angle stop on its outer circumference.

3. The switch cabinet (100) according to claim 1 or 2, in which the passages (5), which are aligned in pairs at least in part, are geometrically substantially identical.

4. The switch cabinet (100) according to any one of the preceding claims, wherein the two sliders (4) are formed as slider plates lying on top of each other and the passages (5) are formed as passages (5) perpendicular to the respective plate plane through the slider plate.

5. The switch cabinet (100) according to any one of the preceding claims, in which a sealing element (7) is mounted in front of an outer side of the outer of the two sliders (4) facing away from the switch cabinet interior.

6. The switch cabinet (100) according to claim 5, wherein the sealing element (7) comprises or is a sponge rubber seal.

7. The switch cabinet (100) according to claim 5 or 6, in which a plurality of empty tubes (8) are passed through the sealing element (7), the empty tubes (8) being enclosed at their outer circumference in a fluidically sealing manner by the sealing element (7).

8. The switch cabinet (100) according to any one of claims 5 to 7, wherein at least for a portion of the pair of aligned passages (5) per pair of aligned passages (5), an empty tube (8) is inserted from the outside of the switch cabinet (100) through the sealing element (7) and the pair of aligned passages (5) into the interior of the switch cabinet.

9. The switch cabinet (100) of any one of claims 5 to 8, wherein the sealing element (7) for all of the paired aligned passages (5) of the sliders (4) has a further passage aligned with each of the paired aligned passages (5) of the sliders (4).

10. The switch cabinet (100) according to any one of the preceding claims, wherein one of the two sliders (4) is immovably fixed to the wall (3) of the switch cabinet (100) and the other slider (4) faces the interior of the switch cabinet and is displaceable with respect to the immovable slider (4).

11. The switch cabinet (100) of claim 1, wherein the threaded screw (12) with a non-circular screw head (11) is a spiral tension screw.

12. The switch cabinet (100) according to claim 1 or 11, wherein the threaded screw (12) or the spiral tensioning screw abuts via its non-circular screw head (11) against opposite inner edges of aligned apertures (23) through the two sliders (4).

13. The switch cabinet (100) according to claim 12, wherein the inner edges are arranged opposite each other in the direction in which the two sliders (4) are displaceable relative to each other.

14. The switch cabinet (100) according to claim 1 or 2, in which an elastic empty tube (8), for example a plastic tube, is introduced into the interior of the switch cabinet via a plurality of the passages (5) aligned in pairs, the two slides (4) being braced relative to one another via the drive (10) with elastic deformation of the empty tubes (8) and thus against a restoring force.

15. The switch cabinet (100) according to any one of the preceding claims, wherein the locking means (6) comprises a threaded receptacle (13) in one of the two slides (4) with a screw element (14) screwed therein, and an elongate hole (22) or keyhole through the other slide (4) extending in the direction in which the two slides (4) are slidable relative to each other and aligned with the threaded receptacle (13).

## Revendications

1. Armoire de commande (100) avec une entrée de conduite (1) pour l'introduction d'une pluralité de fibres optiques (2) à travers un mur (3) de l'armoire de commande (100) dans un intérieur d'armoire de commande, dans lequel l'entrée de conduite (1) comprend deux coulisseaux (4) coulissant parallèlement entre eux, qui comprennent chacun une pluralité de passages (5), qui sont alignés au moins partiellement par paires, dans lequel l'entrée de conduite (1) comprend un moyen d'arrêt (6) grâce auquel les coulisseaux (4) peuvent être arrêtés l'un par rapport à l'autre, **caractérisé en ce que** l'entrée de conduite (1) comprend en outre un entraînement (10) par l'intermédiaire duquel les deux coulisseaux (4) peuvent coulisser parallèlement entre eux, dans lequel l'entraînement (10) comprend une vis (12) avec une tête de vis non circulaire (11) qui s'appuie, par l'intermédiaire de sa tête de vis non circulaire (11), contre un bord interne d'un perçage (23) à travers un des deux coulisseaux (4) ou à travers les deux coulisseaux (4).

2. Armoire de commande (100) avec une entrée de conduite (1) pour l'introduction d'une pluralité de fibres optiques (2) à travers un mur (3) de l'armoire de commande (100) dans un intérieur d'armoire de commande, dans lequel l'entrée de conduite (1) comprend deux coulisseaux (4) coulissant parallèlement entre eux, qui comprennent chacun une pluralité de passages (5), qui sont alignés au moins partiellement par paires, dans lequel l'entrée de conduite (1) comprend un moyen d'arrêt (6) grâce auquel les coulisseaux (4) peuvent être arrêtés l'un par rapport à l'autre, **caractérisé en ce que** l'entrée de conduite (1) comprend en outre un entraînement (10), dans lequel l'entraînement (10) comprend un écrou de serrage (24) qui comprend, sur son côté orienté vers les coulisseaux (4), une spirale de serrage par l'intermédiaire de laquelle l'écrou de serrage (24) pénètre dans un perçage (23) à travers un des deux coulisseaux (4) ou à travers les deux coulisseaux (4) et qui est réalisée de manière excentrique autour d'un passage pour une vis (12) et qui comprend, sur sa circonférence externe, une butée angulaire en saillie.

3. Armoire de commande (100) selon la revendication 1 ou 2, dans laquelle les passages (5) alignés au moins partiellement par paires présentent des formes géométriques globalement identiques.

4. Armoire de commande (100) selon l'une des revendications précédentes, dans laquelle les deux coulisseaux (4) sont conçus comme des plaques coulissantes superposées et les passages (5) sont conçus comme des passages (5) perpendiculaires au plan respectif des plaques à travers la plaque coulissante.

5. Armoire de commande (100) selon l'une des revendications précédentes, dans laquelle, en amont d'un côté externe, opposé à l'intérieur de l'armoire de commande, du plus extérieur des deux coulisseaux (4), est disposé un élément d'étanchéité (7).

6. Armoire de commande (100) selon la revendication 5, dans laquelle l'élément d'étanchéité (7) comprend ou est un joint d'étanchéité en caoutchouc cellulaire.

7. Armoire de commande (100) selon la revendication 5 ou 6, dans laquelle une pluralité de conduites (8) traversent l'élément d'étanchéité (7), dans lequel les conduites (8) sont entourées, sur la circonférence externe, de manière étanche aux fluides, par l'élément d'étanchéité (7).

8. Armoire de commande (100) selon l'une des revendications 5 à 7, dans laquelle, au moins pour une partie des passages alignés par paires (5), au niveau de chaque paire de passages alignés (5), est insérée une conduite (8) à partir du côté extérieur de l'armoire de commande (100) à travers l'élément d'étanchéité (7) et la paire de passages alignés (5) vers l'intérieur de l'armoire de commande.

9. Armoire de commande (100) selon l'une des revendications 5 à 8, dans laquelle l'élément d'étanchéité (7) comprend, pour l'ensemble des passages alignés par paires (5) des coulisseaux (4), un autre passage qui est aligné avec les passages alignés par paires (5) des coulisseaux (4).

10. Armoire de commande (100) selon l'une des revendications précédentes, dans laquelle un des deux coulisseaux (4) est fixé de manière immobile à la paroi (3) de l'armoire de commande (100) et l'autre coulisseau (4) est orienté vers l'intérieur de l'armoire de commande et peut coulisser par rapport au coulisseau (4) immobile.

11. Armoire de commande (100) selon la revendication 1, dans laquelle la vis (12) avec une tête de vis non circulaire (11) est une vis de serrage hélicoïdale.

12. Armoire de commande (100) selon la revendication 1 ou 11, dans laquelle la vis (12) ou la vis de serrage hélicoïdale s'appuie, par l'intermédiaire de sa tête de vis non circulaire (11), contre des bords internes opposés de perçages alignés (23) à travers le deux coulisseaux (4).

13. Armoire de commande (100) selon la revendication 12, dans laquelle les bords internes se font face dans la direction dans laquelle les deux coulisseaux (4) peuvent coulisser l'un par rapport à l'autre.

14. Armoire de commande (100) selon la revendication 1 ou 2, dans laquelle, grâce à chacun d'une pluralité de passages alignés par paires (5), une conduite élastique (8), par exemple un tuyau en matière plastique, est introduit à l'intérieur de l'armoire de commande, dans lequel les deux coulisseaux (4) sont serrés entre eux par l'intermédiaire de l'entraînement (10) avec une déformation élastique des conduites (8) et donc contre une force de rappel.

15. Armoire de commande (100) selon l'une des revendications précédentes, dans laquelle le moyen d'arrêt (6) comprend un logement fileté (13) dans un des deux coulisseaux (4), avec un élément fileté (14) vissé à l'intérieur, ainsi qu'un trou oblong (22) ou un trou de serrure à travers l'autre coulisseau (4), qui s'étend dans la direction dans laquelle les deux coulisseaux (4) peuvent coulisser l'un par rapport à l'autre et qui est aligné avec le logement fileté (13).
